(19) Europäisches Patentamt
European Patent Office
Office européen des brevets

(11) EP 0 881 583 A2

## (12) EUROPEAN PATENT APPLICATION

(43) Date of publication:
02.12.1998 Bulletin 1998/49

(51) Int. Cl.⁶: $G06F\ 17/11$, $G06F\ 17/50$

(21) Application number: 98250183.5

(22) Date of filing: 27.05.1998

(84) Designated Contracting States:
AT BE CH CY DE DK ES FI FR GB GR IE IT LI LU
MC NL PT SE
Designated Extension States:
AL LT LV MK RO SI

(30) Priority: 27.05.1997 JP 136591/97

(71) Applicant: NEC CORPORATION
Tokyo (JP)

(72) Inventor: Kamashiro, Shigetaka
Minato-ku, Tokyo (JP)

(74) Representative:
Patentanwälte Wenzel & Kalkoff
Grubesallee 26
22143 Hamburg (DE)

(54) **Fill-in generator for incomplete LU-factorization processing and method thereof**

(57) A fill-in generation device for executing preconditioning by incomplete LU-factorization to generate a fill-in in order to conduct matrix solver for solving multi-dimensional simultaneous linear equations in semiconductor device manufacturing process simulations, including a parameter setting unit (101) for setting necessary parameters so as to reflect physical phenomena of equations to be solved, a fill-in level calculation unit (106) for calculating a level of a fill-in whose generation is possible by using other fill-in levels adopted before the processing, a fill-in level check unit (107) for controlling a fill-in generation position based on a result of comparison between a calculated value of a fill-in level and a threshold value, and a fill-in element calculation unit (108).

FIG. 1

EP 0 881 583 A2

**Description**

BACKGROUND OF THE INVENTION

FIELD OF THE INVENTION

The present invention relates to a fill-in generator for incomplete LU-factorization processing for use as preconditioning of matrix solver which solves multi-dimensional simultaneous linear equations derived from physical laws by using an iteration method such as the ICCG method or the Krylov Subspace Method in computer simulations of semiconductor device manufacturing processes and electrical characteristics.

DESCRIPTION OF THE RELATED ART

In computer simulations of impurity thermal diffusion which is one of semiconductor device manufacturing processes, as recited in the literature "Process Device Simulation Technique" (written and edited by Ryo Dan, Sangyo Library, 1990 (hereinafter referred to as Literature 1)) on pages 26 to 28, a region to be analyzed is divided into meshes and at each mesh point, a diffusion equation is discretized and subsequently linearized by the Newton method or other method to convert into simultaneous linear equations so as to solve the diffusion equation.

On the other hand, electrical characteristics of a semiconductor device manufactured through manufacturing processes including impurity thermal diffusion, ion implantation and thermal oxidation, as recited on pages 105 to 134 of Literature 1, can be simulated on a computer by dividing a region to be analyzed into meshes, discretizing a Poisson equation and a current continuity equation at each mesh point, subsequently linearizing the equations by the Newton method or other method to convert into simultaneous linear equations and solving the same.

In these semiconductor device process simulations, it is essential for practical use to solve large-scale simultaneous linear equations having as many dimensions as the number of mesh points by as high-speed and as small memories as possible. The function of solving these simultaneous linear equations is called "matrix solver", for which various techniques are proposed. For an equation having few dimensions, Gaussian Elimination or the direct method whose representative is LU-factorization is used, while for an equation having many dimensions, the iteration method is employed because of constraints on the amount of memory needed and a calculation time. Of the iteration methods, the ICCG method is by preference used for simultaneous linear equations to be solved whose coefficient matrix is symmetric and a series of techniques called Krylov Subspace Method is by preference used for those whose coefficient matrix is asymmetric because of advantages in convergence.

By forming an algorithm of multiplying an original coefficient matrix of an equation to be solved by an approximate inverse matrix of the coefficient matrix, both the ICCG method and the Krylov Subspace Method allow the number of conditions of the coefficient matrix to be reduced to solve the equation by a reduced number of iteration. This operation will be referred to as "preconditioning" and an approximate inverse matrix of a coefficient matrix will be referred to as "preconditioning matrix". Most commonly used as an inverse matrix of a preconditioning matrix is a matrix obtained by "incomplete LU-factorization" by which an original coefficient matrix is LU-factorized, with a fill-in generation position limited.

Fill-in here denotes that in the process of LU-factorization:

$$a_{jk} = a_{jk} - a_{ji} \cdot a_{ik},$$

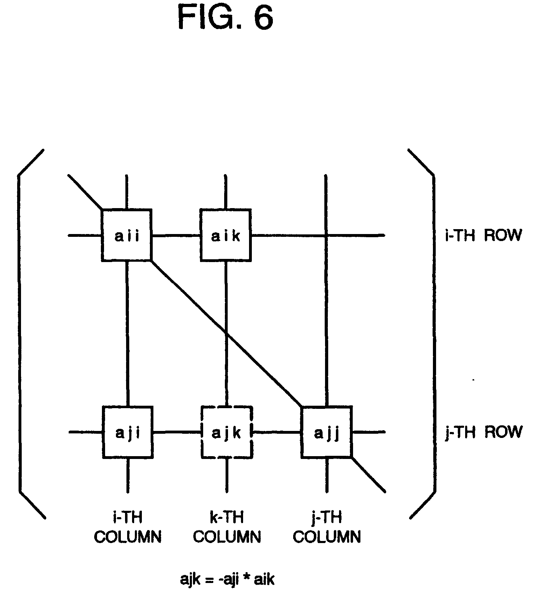

a new element is generated at a position $(j, k)$ where no element exists in an original coefficient matrix as shown in Fig. 6. Taking all generated fill-ins into consideration leads to ordinary complete LU-factorization. In Fig. 6, an element "$a_{jk}$" represents a fill-in element which will be newly generated at a position of the j row, the k column from an element "$a_{ji}$" in the j row, the i column and an element "$a_{ik}$" in the i row, the k column.

Importance for the preconditioning by incomplete LU-factorization is setting an optimum fill-in generation pattern which satisfies, at a time and at a level as high as possible, two contradictory conditions of reducing generation of fill-ins to suppress increase in the amount of memory needed and in a calculation time and obtaining results approximate to those obtained by complete LU-factorization to increase convergence of an iteration method.

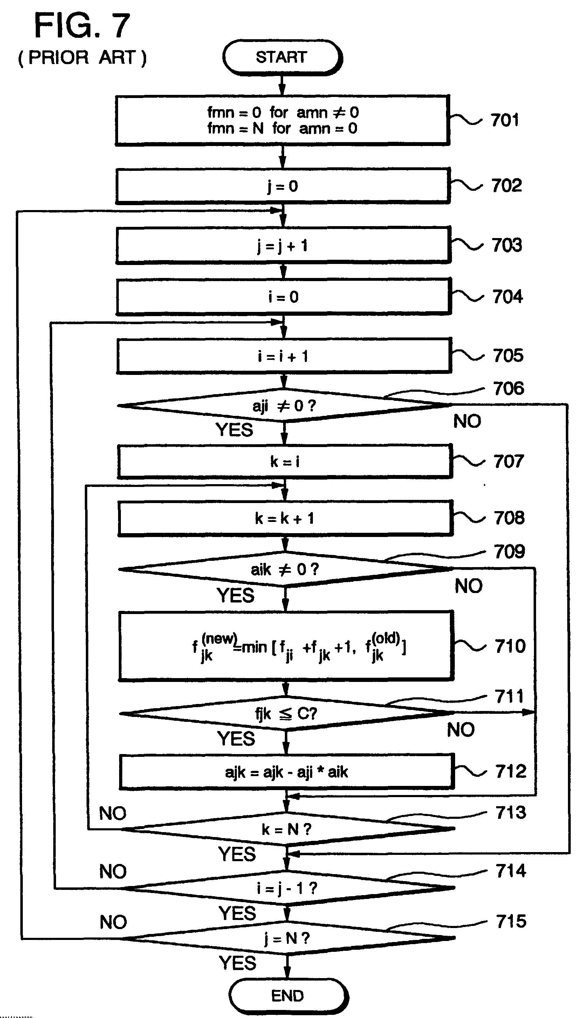

One of conventional methods of setting a fill-in generation pattern is recited, for example, in Y. Saad, "Krylov Subspace Method on Supercomputers, in SIAM J. Sci. Stat. Comput." (Vol. 10, No. 6, pp. 1200-1232, November 1989) on page 1203, lines 31 to 36. In the method disclosed in this literature (hereinafter referred to as Related Art I), a "fill-in level" is set for each element in a matrix to be incompletely LU-factorized and the fill-in level is used according to the algorithm shown in Fig. 7 to determine a fill-in generation position.

With reference to Fig. 7, according to the method of Related Art 1, a fill-in level of a nonzero element position in a matrix to be incompletely LU-factorized is set to "0" and a fill-in level of a zero element position is set to a matrix size "N" (Step 701). Next, a row number "j" at which a factorized element value is to be actually calculated at the time of incomplete LU-factorization is initialized to "0" (Step 702) and put forward by one (Step 703). In addition, a row number "i" whose element is to be referred to at the time of incomplete LU-factorization is initialized to "0" (Step 704) and put forward by one (Step 705). Next, whether an element "$a_{ji}$" in the j row, the i column exists or not is checked (Step 706) and when it exists, the routine proceeds to the subsequent Step 707; otherwise the routine proceeds to Step 714.

When the element "$a_{ji}$" exists at Step 706, a column number "k" at which a factorized element value is to be actually calculated at the time of incomplete LU-factorization is initialized to "i" (Step 707) and put forward by one (Step 708). Then, whether an element "$a_{ik}$" in the i row, the k column exists or not is checked (Step 709) and when it exists, the routine proceeds to the subsequent Step 710; otherwise the routine proceeds to Step 713. When the element "$a_{ik}$" exists at Step 709, a value obtained by adding one to a sum of a fill-in level of the j row, the i column and a fill-in level of the i row, the k column is compared with a fill-in level of the j row, the k column and a smaller one of the two levels is newly set as a fill-in level of the j row, the k column (Step 710). Next, the fill-in level of the j row, the k column is compared with a preset threshold value "C" (Step 711) and when it is not more than "C", it is formally adopted as a fill-in to proceed to Step 712. When it is higher than "C", it is discarded as a fill-in to proceed to Step 713.

When the fill-in level of the j row, the k column is not more than the threshold value "C" at Step 711, a value of an element "$a_{jk}$" newly generated as a fill-in in the j row, the k column is calculated according to the expression $a_{jk} = a_{jk} - a_{ji} \cdot a_{ik}$ (Step 712) and a calculation result is stored in a storage region of a computer. Next, whether the target "k" reaches the preset matrix size "N" or not is checked (Step 713) and when it reaches N, the routine proceeds to the subsequent Step 714; otherwise the routine returns to Step 708. When "k" reaches "N", whether a target "i" reaches "j-1" is next checked (Step 714) and when it reaches "N", the routine proceeds to Step 715; otherwise the routine returns to Step 705. When "i" reaches "j-1", whether "j" reaches "N" is next checked (Step 715) and when it reaches "N", incomplete LU-factorization is finished; otherwise the routine returns to Step 703.

Another conventional method of setting a fill-in generation pattern is disclosed, for example, in C Pommerell and W Fichtner, "An Iterative Linear Solver Package for Ill-Conditioned Systems" (Technical Report No.91/5, Integrated System Laboratory ETH, 1991) on page 6, lines 8 to 14. The method disclosed in the literature (hereinafter referred to as Related Art 2) employs a system of calculating a value of a fill-in element actually generated in the process of incomplete LU-factorization and actually adopting the fill-in element as a fill-in only when the calculated value has an absolute value having a difference more than or equal to a fixed value from an element having the maximum absolute value in a row where the fill-in generated.

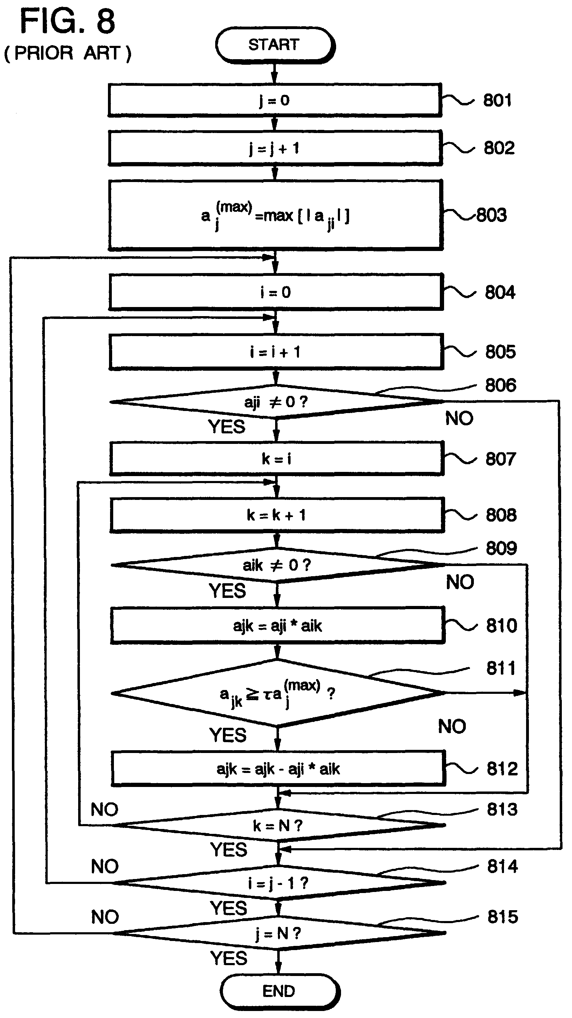

With reference to a flow chart of Fig. 8 showing the method of Related Art 2, first, a row number "j" at which a factorized element value is to be actually calculated at the time of incomplete LU-factorization is initialized to "0" (step 801) and put forward by one (Step 802). Next, a maximum absolute value "$a_j^{(max)}$" of the elements in the j row is obtained (Step 803). In addition, a row number "i" whose element is to be referred to at the time of incomplete LU-factorization is initialized to "0" (Step 804) and put forward by one (Step 805). Next, whether an element "$a_{ji}$" in the j row, the i column exists or not is checked (Step 806) and when it exists, the routine proceeds to the subsequent Step 807; otherwise the routine proceeds to Step 814.

When there exists the element "$a_{ji}$" at Step 806, a column number "k" at which a factorized element value is to be actually calculated at the time of incomplete LU-factorization is initialized to "i" (Step 807) and put forward by one (Step 808). Next, whether an element "$a_{ik}$" in the i row, the k column exists is checked (Step 809) and when it exists, the routine proceeds to the subsequent Step 810; otherwise the routine proceeds to Step 813. When the element "$a_{ik}$" exists at Step 809, an element value "$a_{jk}$" to be added to the j row, the k column as a fill-in is calculated according to the expression $a_{jk} = a_{ji} \cdot a_{ik}$ (Step 810).

Next, the value of the element "$a_{jk}$" is compared with a value obtained by multiplying "$a_j^{(max)}$" by $\tau$ (Step 811) and when the value of the element "$a_{jk}$" is not less than the value of "$\tau a_j^{(max)}$", it is formally adopted as a fill-in to proceed to the subsequent Step 812. On the other hand, when the value of the element "$a_{jk}$" is smaller than "$\tau a_j^{(max)}$", it is discarded as a fill-in to proceed to Step 813. When the value of the element "$a_{jk}$" is not less than the value of "$\tau a_j^{(max)}$", a value of the element "$a_{jk}$" newly generated in the j row, the k column as a fill-in is calculated according to the expression $a_{jk} = a_{jk} - a_{ji} \cdot a_{ik}$ (Step 812) and stored in a storage region of a computer.

On the other hand, when the value of the element "$a_{jk}$" is smaller than "$\tau a_j^{(max)}$", whether "k" reaches the preset matrix size "N" or not is checked (Step 813) and if it reaches N, the routine proceeds to Step 814; otherwise the routine returns to Step 808. When "k" reaches "N" at Step 813, whether "i" reaches "j-1" or not is then checked (Step 814) and when it reaches "j-1", the routine proceeds to the subsequent Step 815; otherwise the routine returns to Step 805. When "i" reaches "j-1" at Step 814, whether "j" reaches "N" or not is then checked (Step 815) and if it reaches N, incomplete LU-factorization is finished; otherwise the routine returns to Step 804.

Drawback of the above-described Related Art 1 is that since a fill-in generation position is uniformly determined depending solely on an element arrangement of an original matrix, strengths of coupling between variables in equations and coupling between equations are not taken into consideration to make approximation of incomplete LU-factorization to complete LU-factorization low.

On the other hand, Related Art 2 has none of such a shortcoming as that of Related Art 1 because adoption or discard is determined while actually checking the size of a fill-in element generated in the process of the execution of numerical incomplete LU-factorization. However, since determination of a fill-in generation position is made at the stage of numerical incomplete LU-factorization, solution of a nonlinear equation by the Newton method results in changing an element value of a coefficient matrix at every iteration of the Newton Method, so that a fill-in generation position varies each time. As a result, it is necessary to restructure a region on a computer for storing an incompletely LU-factorized matrix element each time, which makes a procedure complicated to increase a time required for processing. In terms of restructuring of a storage region, Related Art 1 is superior, in which a fill-in position is determined by simulating incomplete LU-factorization only once at the time when not an actual element value of a coefficient matrix but an arrangement of a nonzero element is given. This operation is called "symbolic incomplete LU-factorization".

## SUMMARY OF THE INVENTION

An object of the present invention is to provide a fill-in generation device which eliminates the above-described conventional shortcomings and realizes a technique of incomplete LU-factorization enabling a fill-in generation position to be effectively determined taking strengths of coupling between variables of equations and between equations into consideration, as well as requiring the determination to be made only once at the time of symbolic incomplete LU-factorization, and a method thereof.

According to the first aspect of the invention, a fill-in generation device for executing, in order to conduct matrix solver for solving multi-dimensional simultaneous linear equations by an iteration method subjected to preconditioning by incomplete LU-factorization in semiconductor device manufacturing process simulations, preconditioning by said incomplete LU-factorization to generate a fill-in, comprises

parameter setting means for setting an initial fill-in level, a coupling strength $E(i,j)$ between an i-th equation and a j-th equation, a coupling strength $S_i(k)$ of other k-th variable with an i-th principal variable constituting the i-th equation and a coupling strength $S_j(i)$ of other i-th variable with a j-th principal variable constituting the j-th equation so as to reflect physical phenomena of equations to be solved,

fill-in level calculation means for calculating, at the time of symbolic incomplete LU-factorization conducted for determining a fill-in generation position before said incomplete LU-factorization is numerically conducted, a level of a fill-in whose generation is possible according to a calculation expression using a fill-in level $f_{ik}^{(old)}$ in the i row, the k column and a fill-in level $f_{ji}^{(old)}$ in the j row, the i column adopted before the processing,

a fill-in level check means for, when the value of said fill-in level calculated by said fill-in level calculation means is not more than a preset threshold value, adopting said fill-in as a fill-in and when the same is more than the threshold value, discarding said fill-in to control a fill-in generation position, and

fill-in element calculation means for calculating a value of an element newly generated at a fill-in generation position whose adoption is determined by said fill-in level check means.

In the preferred construction, said fill-in level calculation means calculates a level $f_{jk}^{(new)}$ of said fill-in whose generation is possible according to the following expressions:

$$f_{jk}^{(eval)} = \left( \frac{f_{ik}}{S_i(k)} \cdot \frac{f_{ji}}{S_j(i)} \right) \frac{1}{E(i,j)}$$

$$f_{jk}^{(new)} = \min[f_{jk}^{(eval)}, f_{jk}^{(old)}]$$

In another preferred construction, said fill-in level calculation means calculates a level $f_{jk}^{(new)}$ of said fill-in whose generation is possible according to the following expressions:

$$f_{jk}^{(eval)} = \left( \frac{f_{ik}}{S_i(k)} + \frac{f_{ji}}{S_j(i)} \right) \frac{1}{E(i,j)}$$

$$f_{jk}^{(new)} = \min[f_{jk}^{(eval)}, f_{jk}^{(old)}]$$

According to the second aspect of the invention, a fill-in generation method for executing, in order to conduct matrix solver for solving multidimensional simultaneous linear equations by an iteration method subjected to preconditioning by incomplete LU-factorization in semiconductor device manufacturing process simulations, preconditioning by said incomplete LU-factorization to generate a fill-in, comprising the steps of

setting an initial fill-in level, a coupling strength $E(i,j)$ between an i-th equation and a j-th equation, a coupling strength $S_i(k)$ of other k-th variable with an i-th principal variable constituting the i-th equation and a coupling strength $S_j(i)$ of other i-th variable with a j-th principal variable constituting the j-th equation so as to reflect physical phenomeena of equations to be solved,

calculating, at the time of symbolic incomplete LU-factorization conducted for determining a fill-in generation position before said incomplete LU-factorization is numerically conducted, a level of a fill-in whose generation is possible according to a calculation expression using a fill-in level $f_{ik}^{(old)}$ in the i row, the k column and a fill-in level $f_{ji}^{(old)}$ in the j row, the i column adopted before the processing,

when the value of said fill-in level calculated at said fill-in level calculation step is not more than a preset threshold value, adopting said fill-in as a fill-in and when the same is more than the threshold value, discarding said fill-in to control a fill-in generation position, and

calculating a value of an element newly generated at a fill-in generation position whose adoption is determined by said fill-in level checking step.

In this case, at said fill-in level calculation step, a level $f_{jk}^{(new)}$ of said fill-in whose generation is possible is calculated according to the following expressions:

$$f_{jk}^{(eval)} = \left( \frac{f_{ik}}{S_i(k)} \cdot \frac{f_{ji}}{S_j(i)} \right) \frac{1}{E(i,j)}$$

$$f_{jk}^{(new)} = \min[f_{jk}^{(eval)}, f_{jk}^{(old)}]$$

Also, at said fill-in level calculation step, a level $f_{jk}^{(new)}$ of said fill-in whose generation is possible is calculated according to the following expressions:

$$f_{jk}^{(eval)} = \left( \frac{f_{ik}}{S_i(k)} + \frac{f_{ji}}{S_j(i)} \right) \frac{1}{E(i,j)}$$

$$f_{jk}^{(new)} = \min[f_{jk}^{(eval)}, f_{jk}^{(old)}]$$

Other objects, features and advantages of the present invention will become clear from the detailed description given herebelow.

BRIEF DESCRIPTION OF THE DRAWINGS

The present invention will be understood more fully from the detailed description given herebelow and from the accompanying drawings of the preferred embodiment of the invention, which, however, should not be taken to be limitative to the invention, but are for explanation and understanding only.

In the drawings:

Fig. 1 is a block diagram showing structure of a fill-in generation device according to one embodiment of the present invention.

Fig. 2 is a flow chart showing a method of generating a fill-in for incomplete LU-factorization according to the present embodiment.

Fig. 3 is a diagram showing a state of generation of a fill-in in the process of LU-factorization in the operation example shown in Fig.2.

Fig. 4 is a diagram showing a relationship between a mesh and a control volume for use in discretization of an impurity - point defect pair diffusion model.

Fig. 5 is a flow chart showing another method of generating a fill-in for incomplete LU-factorization according to the present embodiment.

Fig. 6 is a diagram showing a state of generation of a fill-in in the process of LU-factorization in the operation example shown in Fig. 5.

Fig. 7 is a flow chart showing a conventional method of generating a fill-in for incomplete LU-factorization.

Fig. 8 is a flow chart showing another conventional method of generating a fill-in for incomplete LU-factorization.

DESCRIPTION OF THE PREFERRED EMBODIMENT

The preferred embodiment of the present invention will be discussed hereinafter in detail with reference to the accompanying drawings. In the following description, numerous specific details are set forth in order to provide a thorough understanding of the present invention. It will be obvious, however, to those skilled in the art that the present invention may be practiced without these specific details. In other instance, well-known structures are not shown in detail in order to unnecessary obscure the present invention.

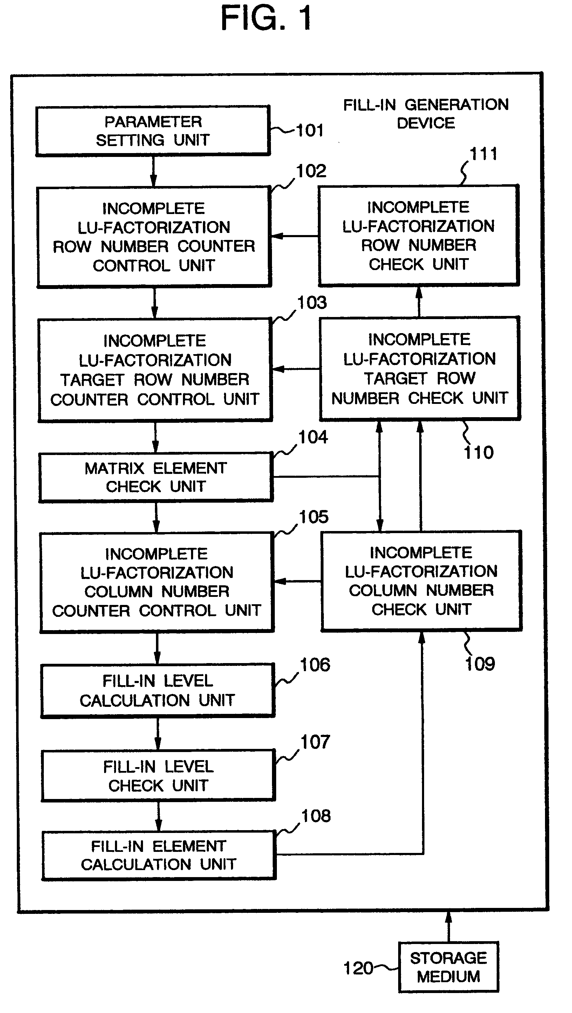

Fig. 1 is a block diagram showing structure of a fill-in generation device according to one embodiment of the present invention. With reference to Fig. 1, a fill-in generation device 100 of the present embodiment includes a parameter setting unit 101, an incomplete LU-factorization row number counter control unit 102, an incomplete LU-factorization target row number counter control unit 103, an incomplete LU-factorization column number counter control unit 104, a matrix element check unit 105, a fill-in level calculation unit 106, a fill-in level check unit 107, a fill-in element calculation unit 108, an incomplete LU-factorization column number check unit 109, an incomplete LU-factorization target row number check unit 110 and an incomplete LU-factorization row number check unit 111. In Fig. 1, illustration is made only of a characteristic part of the structure of the present embodiment and that of the remaining common part is omitted.

Each component of the present embodiment is implemented by program-controlled CPU and internal memory of a workstation or a personal computer. The control program which controls the CPU is stored in a storage medium 120 for provision and is loaded to execute each of the above functions. Used as the storage medium 120 is a magnetic disk, an optical disk, a semiconductor memory or other common storage medium.

In the above structure, the parameter setting unit 101 sets an initial fill-in level, a strength of coupling between variables and a strength of coupling between equations. The incomplete LU-factorization row number counter control unit 102 initializes a counter of a row number to be incompletely LU-factorized and puts a row number forward by one with the progress of the processing. The incomplete LU-factorization target row number counter control unit 103 initializes a counter of a row number of a partner for incomplete LU-factorization and puts the row number of the partner forward by one with the progress of the processing.

The incomplete LU-factorization column number counter control unit 104 initializes a counter of a column number to be incompletely LU-factorized and puts the column number forward by one with the progress of the processing. The matrix element check unit 105 checks whether an element "$a_{ji}$" in the j row, the i column and an element "$a_{ik}$" in the i row, the k column are "0" or not. The fill-in level calculation unit 106 calculates a fill-in level of a fill-in whose new generation is possible. The fill-in level check unit 107 checks whether a calculated fill-in level is not more than a preset threshold value. The fill-in element calculation unit 108 calculates a value of a fill-in element.

The incomplete LU-factorization column number check unit 109 checks whether a column number to be incompletely LU-factorized reaches a matrix size "N" or not. The incomplete LU-factorization target row number check unit 110 checks whether a row number of a partner for incomplete LU-factorization reaches "j-1" nor not. The incomplete LU-factorization row number check unit 111 checks whether a row number to be incompletely LU-factorized reaches the matrix size N or not.

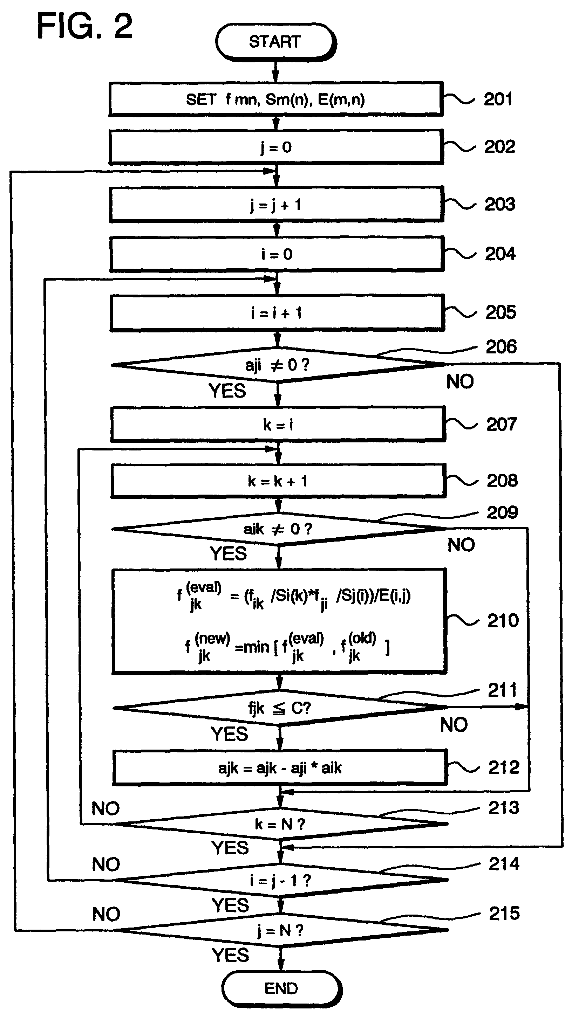

Next, with respect to a case where an impurity - point defect pair diffusion equation is solved by the Newton method, detailed description will be made of the present embodiment with reference to the drawings. Fig. 2 is a flow chart showing a fill-in generation method according to the present embodiment. With reference to Fig. 2, the parameter setting unit 101 first sets an initial value of a fill-in level $f_{mn}$ in the m row, the n column and sets a coupling strength $S_m(n)$ between a principal variable and an n-th variable of an m-th equation and a coupling strength $E(m,n)$ between the m-th equation and an n-th equation with respect to every "m" ($0 \leq m \leq N$) and "n" ($0 \leq n \leq N$) (Step 201). Here, the coupling strength $S_m(n)$ between the principal variable and the n-th variable of the m-th equation represents a coupling strength between a principal diagonal element in the m row (element in the m row, the m column) and an element in the m row, the n column and N represents a dimension of the equation.

Next, the incomplete LU-factorization row number counter control unit 102 initializes a row number "j" at which a factorized element value is to be actually calculated at the time of incomplete LU-factorization to "0" (Step 202) and puts "j" forward by one (Step 203). Then, the incomplete LU-factorization target row number counter control unit 103 initializes a row number "i" whose element is to be referred to at the time of incomplete LU-factorization to "0" (Step 204) and puts "i" forward by one (Step 205). Next, the matrix element check unit 105 checks whether there exists an element "$a_{ji}$" in the j row, the i column (Step 206) and when it exits, the routine proceeds to Step 207; otherwise the routine proceeds to Step 214.

When the element "$a_{ji}$" exists at Step 206, a column number "k" at which a factorized element value is to be actually calculated at the time of incomplete LU-factorization is initialized to "i" (Step 207) and put forward by one (Step 208). Then, the matrix element check unit 105 checks whether an element "$a_{ik}$" in the i row, the k column exists (Step 209) and when it exists, the routine proceeds to the subsequent Step 210; otherwise the routine proceeds to Step 213.

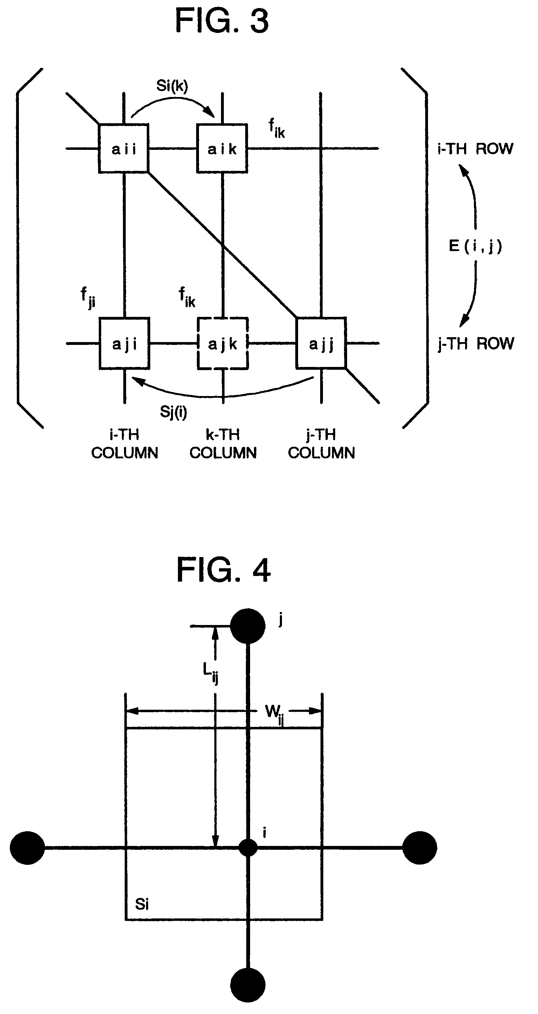

When, the element "$a_{ik}$" exists at Step 209, the fill-in level calculation unit 106 sets a fill-in level $f_{jk}^{(new)}$ in the j row, the k column as shown in the following expressions (1) and (2) by using a fill-in level $f_{ik}$ in the i row, the k column, a coupling strength $S_i(k)$ of other k-th variable with an i-th principal variable constituting an i-th equation, a fill-in level $f_{ji}$ in the j row, the i column, a coupling strength $S_j(i)$ of other i-th variable with a j-th principal variable constituting a j-th equation, a coupling strength $E(i,j)$ between the i-th equation and the j-th equation (i.e. the i row and the j row) shown in Fig. 3 and a fill-in level $f_{jk}^{(old)}$ in the j row, the k column adopted before the processing (Step 210).

$$f_{jk}^{(eval)} = \left( \frac{f_{ik}}{S_i(k)} \cdot \frac{f_{ji}}{S_j(i)} \right) \frac{1}{E(i,j)} \qquad (1)$$

$$f_{jk}^{(new)} = \min[f_{jk}^{(eval)}, f_{jk}^{(old)}] \qquad (2)$$

In the above expression (2), min[ , ] denotes that a smaller one of two values in [ ] is set as a fill-in level $f_{jk}^{(new)}$ in the j row, the k column. As mentioned before, complete LU-factorization adopts all elements generated as a fill-in, while incomplete LU-factorization adopts a part of them and discards the remainder. For making determination of adoption or discard, a numerical label is assigned according to the degree of importance of a generated fill-in. Value of this label represents a fill-in level. Coupling strength $S_i(k)$ of other k-th variable with the i-th principal variable constituting the i-th equation represents a coupling strength between a principal diagonal element in the i row (element in the i row, the i column) and an element in the i row, the k column and coupling strength $S_j(i)$ of other i-th variable with the j-th principal variable constituting the j-th equation similarly represents a coupling strength between a principal diagonal element in the j row (element in the j row, the j column) and an element in the j row, the i column.

Next, the fill-in level check unit 107 compares the fill-in level $f_{jk}$ in the j row, the k column set at Step 210 with a preset threshold value "C" (Step 211) and when the level is not more than "C", it is formally adopted as a fill-in to proceed to Step 211. When, the level is higher than "C", it is discarded as a fill-in to proceed to Step 213.

When the fill-in level $f_{jk}$ is not more than the threshold value "C" at Step 211, the fill-in element calculation unit 108 calculates a value of an element "$a_{jk}$" newly generated as a fill-in in the j row, the k column according to the expression $a_{jk} = a_{jk} - a_{ji} \cdot a_{ik}$ (Step 212) and stores the calculated value of "$a_{jk}$" in a storage region of the computer. Next, the incomplete LU-factorization column number check unit 109 checks whether a value of "k" reaches the matrix size "N" or not (Step 213) and when it reaches N, the routine proceeds to the subsequent Step 214; otherwise the routine returns to Step 208.

When the value of "k" reaches the matrix size "N" at Step 213, the incomplete LU-factorization target row number check unit 110 then checks whether a value of "i" reaches "j-1" (Step 214) and when it reaches "j-1", the routine proceeds to Step 215; otherwise the routine returns to Step 205.

When the value of "i" reaches "j-1" at Step 214, the incomplete LU-factorization row number check unit 111 checks whether a value of "j" reaches the matrix size "N" or not (Step 215) and when it reaches N, the incomplete LU-factorization is finished; otherwise the routine returns to Step 203.

Detailed description will be next made of a method of setting a coupling strength $S_m(n)$ between variables and a coupling strength $E(i, j)$ between equations. Here, consideration will be given to such point defect - impurity pair diffusion equations as represented by the following expressions (3) and (6). This group of equations models a situation where when a point defect concentration goes out of an equilibrium state due to ion implantation, oxidation, or the like, a diffusion constant of an impurity A changes to cause enhanced diffusion or retarded diffusion.

$$\frac{\partial C_A}{\partial t} = \nabla \cdot \left( D_A(C_I, C_V) \nabla C_A + \eta_A \frac{q D_A(C_I, C_V)}{kT} C_A \nabla \psi \right) \qquad (3)$$

$$\frac{\partial C_I}{\partial t} = \nabla \cdot \left( D_I \nabla C_I + \eta_I \frac{q D_I}{kT} C_I \nabla \psi \right) - R_{IV}(C_I, C_V) \qquad (4)$$

$$\frac{\partial C_V}{\partial t} = \nabla \cdot \left( D_V \nabla C_V + \eta_V \frac{q D_V}{kT} C_V \nabla \psi \right) - R_{IV}(C_I, C_V) \qquad (5)$$

$$\eta_A C_A + \eta_I C_I + \eta_I C_I - \eta(\psi) + p(\psi) = 0 \tag{6}$$

In the above expressions, the equation (3) represents a diffusion equation of the impurity A, where $D_A$ ($C_I$, $C_V$) denotes a diffusion constant of A which changes depending on concentrations $C_I$ and $C_V$ of interstitial silicon and vacancy as point defects. $C_A$ denotes a concentration of the impurity A, $\eta_A$ denotes a charged state of A and takes -1 for an acceptor and +1 for a donor. $\psi$ denotes an electrostatic potential. The equation (4) represents a diffusion equation of interstitial silicon, where $D_I$ denotes a diffusion constant of interstitial silicon. $\eta_I$ denotes a charged state of interstitial silicon, which is assumed to take any of -1, 0 and +1. $R_{IV}$ ($C_I$, $C_V$) denotes a recombination rate between interstitial silicon and vacancy. The equation (5) represents a diffusion equation of vacancy, where $D_V$ denotes a diffusion constant of vacancy. $\eta_V$ denotes a charged state of vacancy, which is assumed to take any of -2, -1, 0 and +1. The equation (6) represents a charge neutrality conditional expression which is used for determining a value of an electrostatic potential based on an electron concentration n and a vacancy concentration p.

For solving the above group of equations in two-dimensional space, for example, meshes are made in analytic space to convert each partial differential equation into an algebraic equation through discretization. Assuming, for example, that a partial differential equation to be solved is the following expression (7) and that the meshes are orthogonal for the purpose of simplification, the equation discretized in a real space by using the control volume method at an i-th mesh point will be represented, using symbols shown in Fig. 4, as the following expression (8):

$$\frac{\partial C}{\partial t} = \nabla \cdot (D \nabla C) - R(C) \tag{7}$$

$$S_i \frac{\partial C_i}{\partial t} = \sum_j W_{ij} D(C_i, C_j) \frac{C_j - C_i}{L_{ij}} - S_i R(C_i) \tag{8}$$

where i and j denote mesh points adjacent to each other. $S_i$ denotes a control volume to which the i-th mesh point accounts, $L_{ij}$ denotes a length of a mesh branch connecting the i-th mesh point and its adjacent j-th mesh point and $W_{ij}$ denotes a passage width of a flux flowing on the mesh branch. $\Sigma$ denotes figuring out a sum with respect to the mesh point j adjacent to the i-th mesh point. In addition, $C_i$ denotes a concentration at the i-th mesh point, $C_j$ denotes a concentration at the j-th mesh point, D ($C_i$, $C_j$) denotes a diffusion constant changing depending on $C_i$ and $C_j$, and R ($C_i$) denotes a recombination rate. $C_i$ and $C_j$ are generalization of the above-described $C_I$, $C_V$ and $C_A$. Discretizing the equation (8) in time domain according to the backward Euler method will have the following expression (9):

$$S_i \frac{C_i^m - C_i^{m-1}}{t^m - t^{m-1}} = \sum_j W_{ij} D(C_i^m, C_j^m) \frac{C_j^m - C_i^m}{L_{ij}} - S_i R(C_i^m) \tag{9}$$

where a superscript m denotes a current analysis time and m-1 denotes an analysis time immediately preceding the current analysis time.

Since the simultaneous algebraic equations having as many dimensions as the number of mesh points are nonlinear in general, they will be solved by repeating the operation of solving the following expressions (10) to (13) which are linearized according to the Newton method to obtain $\delta C_i^m$ and updating $C_i^m$ according to the expression $C_i^m = C_i^m + \delta C_i^m$ until $C_i^m$ converges.

$$B_i \delta C_i^m + \sum_j B_j \delta C_j^m = -F_i \tag{10}$$

$$B_i = \frac{S_i}{t^m - t^{m-1}} + \sum_j \frac{W_{ij}}{L_{ij}} \left( D(C_i^m, C_j^m) + \frac{\partial D(C_i^m, C_j^m)}{\partial C_i^m} C_i^m \right) + S_i \frac{\partial R(C_i^m)}{\partial C_i^m} \tag{11}$$

$$B_j = -\frac{W_{ij}}{L_{ij}}\left(D(C_i^m, C_j^m) + \frac{\partial D(C_i^m, C_j^m)}{\partial C_j^m} C_j^m\right) \tag{12}$$

$$F_i = S_i \frac{C_i^m - C_i^{m-1}}{t^m - t^{m-1}} - \sum_j W_{ij} D(C_i^m, C_j^m) \frac{C_j^m - C_i^m}{L_{ij}} - S_i R(C_i^m) \tag{13}$$

Representing the impurity - point defect pair diffusion equations (3) to (6) in the form of the equation (10) results in the following expressions (14) to (17).

$$B_{AAi}\delta C_{Ai} + \sum_j B_{AAj}\delta C_{Aj} + B_{AIi}\delta C_{Ii} + \sum_j B_{AIj}\delta C_{Ij} + B_{AVi}\delta C_{Vi} + \sum_j B_{AVj}\delta C_{Vj} + B_{A\psi i}\delta \psi_i + \sum_j B_{A\psi j}\delta \psi_j = -F_{Ai} \tag{14}$$

$$B_{IIi}\delta C_{Ii} + \sum_j B_{IIj}\delta C_{Ij} + B_{IVi}\delta C_{Vi} + B_{I\psi i}\delta \psi_i + \sum_j B_{I\psi j}\delta \psi_j = -F_{Ii} \tag{15}$$

$$B_{VVi}\delta C_{Vi} + \sum_j B_{VVj}\delta C_{Vj} + B_{VIi}\delta C_{Ii} + B_{V\psi i}\delta \psi_i + \sum_j B_{V\psi j}\delta \psi_j = -F_{Vi} \tag{16}$$

$$B_{\psi\psi i}\delta \psi_i + B_{\psi Ai}\delta C_{Ai} + B_{\psi Ii}\delta C_{Ii} + B_{\psi Vi}\delta C_{Vi} = -F_{\psi i} \tag{17}$$

In the above-described expressions (14) to (17), of three successive subscripts, a first capitalized subscript denotes a kind of equation (impurity A, interstitial silicon I, vacancy V, electrostatic potential $\psi$), a second capitalized subscript denotes a kind of variable, and a third subscript denotes a mesh point. Of two successive subscripts, a first capitalized subscript denotes a kind of variable and a second subscript denotes a mesh point.

Thus composed simultaneous linear equations have the following physical properties.

1) In diffusion equations for interstitial silicon and vacancy, recombination between point defects is more dominative than a diffusion term.

2) Only when impurities and point defects exist at high concentrations, effects of drift component caused by an electrostatic potential is produced.

3) While impurity diffusion is strongly affected by a point defect concentration, point defect diffusion is not so affected by an impurity concentration.

As to the present embodiment, a coupling strength between variables in each equation, for example, in a group of equations defined by an i-th mesh point and its adjacent mesh point j, can be set by the following procedure so as to reflect these physical properties. Denotations of the subscripts are the same as those described with respect to the above expressions (14) to (17).

1) As an initial weight, evenly apply a weight W of 1.0 to all the variables.

$$W_{AAi}=1.0, \ W_{AAj}=1.0, \ W_{AIi}=1.0, \ W_{AIj}=1.0, \tag{18}$$

$$W_{AVi}=1.0, \ W_{AVj}=1.0, \ W_{A\psi i}=1.0, \ W_{A\psi j}=1.0,$$

$$W_{IIi}=1.0, \ W_{IIj}=1.0, \ W_{I\psi i}=1.0, \ W_{I\psi j}=1.0,$$

$$W_{IVi}=1.0,$$

$$W_{VVi}=1.0, \ W_{VVj}=1.0, \ W_{V\psi i}=1.0, \ W_{V\psi j}=1.0,$$

$$W_{VIi}=1.0,$$

$$W_{\psi\psi i}=1.0, \ W_{\psi Ai}=1.0, \ W_{\psi Ii}=1.0, \ W_{\psi Vi}=1.0$$

2) Add a weight of 1.0 to variables having adjacent mesh points which constitute a diffusion term $\triangledown (D\triangledown C)$.

$$W_{AAi}=2.0, \ W_{AAj}=2.0, \ W_{IIi}=2.0, \ W_{IIj}=2.0, \qquad\qquad (19)$$

$$W_{VVi}=2.0, \ W_{VVj}=2.0$$

3) Add a weight of 1.0 to a variable constituting a recombination term.

$$W_{IIi}=3.0, \ W_{IVi}=2.0, \ W_{VVi}=3.0, \ W_{VIi}=2.0 \qquad\qquad (20)$$

4) By a weight of a principal variable of a constituent equation, divide a weight of other variable to obtain a coupling strength between variables.

$$S_{AAi}(AAj)=W_{AAj}/W_{AAi}=1.0, \qquad\qquad (21)$$

$$S_{AAi}(AIi)=W_{AIi}/W_{AAi}=0.5, \ S_{AAi}(AIj)=W_{AIj}/W_{AAi}=0.5,$$

$$S_{AAi}(AVi)=W_{AVi}/W_{AAi}=0.5, \ S_{AAi}(AVj)=W_{AVj}/W_{AAi}=0.5,$$

$$S_{AAi}(A\psi i)=W_{A\psi i}/W_{AAi}=0.5, \ S_{AAi}(A\psi j)=W_{A\psi j}/W_{AAi}=0.5,$$

$$S_{IIi}(IIj)=W_{IIj}/W_{IIi}=0.667, \ S_{IIi}(IVi)=W_{IVi}/W_{IIi}=0.667,$$

$$S_{IIi}(I\psi i)=W_{I\psi i}/W_{IIi}=0.333,$$

$$S_{IIi}(I\psi j)=W_{I\psi j}/W_{IIi}=0.333,$$

$$S_{VVi}(VVj)=W_{VVj}/W_{VVi}=0.667, \ S_{VVi}(VIi)=W_{VIi}/W_{VVi}=0.667,$$

$$S_{VVi}(V\psi i)=W_{V\psi i}/W_{VVi}=0.333,$$

$$S_{VVi}(V\psi j)=W_{V\psi j}/W_{VVi}=0.333,$$

$$S_{\psi\psi i}(\psi Ai)= W_{\psi Ai}/W_{\psi\psi i}=1.0,$$

$$S_{\psi\psi i}(\psi Ii)= W_{\psi Ii}/W_{\psi\psi i}=1.0,$$

$$S_{\psi\psi i}(\psi Vi)= W_{\psi Vi}/W_{\psi\psi i}=1.0,$$

5) Set a coupling strength between variables having mesh points not adjacent to each other which has not been defined by the steps 1 to 4 all to 0.25.

A coupling strength between equations can be set by such procedure as follows.

1) Apply an initial coupling strength of 1.0 between all the equations having mesh points adjacent to each other.

$$E(A_i, A_j)=1.0, \qquad\qquad (22)$$

$$E(A_i, I_i)=1.0, \ E(A_i, I_j)=1.0,$$

$$E(A_i, V_i)=1.0, \ E(A_i, V_j)=1.0,$$

$$E(A_i, \psi_i)=1.0, \ E(A_i, \psi_j)=1.0,$$

$$E(I_i, I_j)=1.0,$$

$$E(I_i, V_i)=1.0, E(I_i, V_j)=1.0,$$

$$E(I_i, \psi_i)=1.0, E(I_i, \psi_j)=1.0,$$

$$E(V_i, V_j)=1.0,$$

$$E(V_i, \psi_i)=1.0, E(V_i, \psi_j)=1.0,$$

$$E(\psi_i, \psi_j)=1.0$$

2) Add a coupling strength of 1.0 to a diffusion equation having the same diffusion kind as a principal variable.

$$E(A_i, A_j)=2.0, E(I_i, I_j)=2.0, \tag{23}$$

$$E(V_i, V_j)=2.0, E(\psi_i, \psi_j)=2.0$$

3) Add a coupling strength of 1.0 to equations on the same mesh point sharing a recombination term.

$$E(I_i, V_i)=2.0 \tag{24}$$

4) Add a coupling strength of 0.5 between a charge neutrality conditional expression and a diffusion equation on the same mesh point.

$$E(A_i, \psi_j)=1.5, E(I_i, \psi_j)=1.5, E(V_i, \psi_j)=1.5 \tag{25}$$

5) Set a coupling strength between equations having mesh points not adjacent to each other which has not been defined by the steps 1 to 4 all to 0.5.

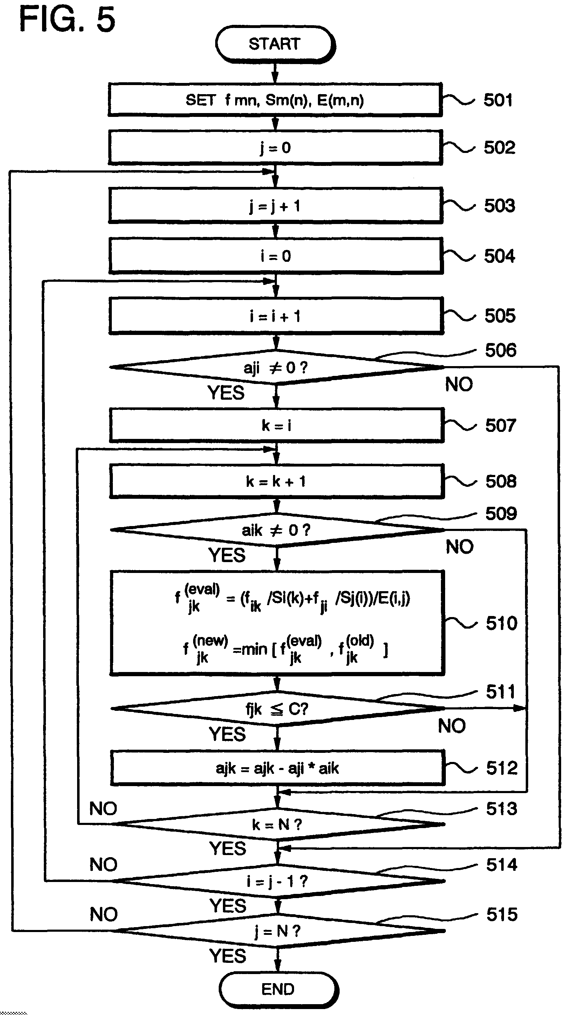

Description will be next made of another example of operation of the present embodiment. Fig. 5 is a flow chart showing another example of a fill-in generation method according to the present embodiment. In Fig. 5, operation at Steps 501 to 509 is the same as the operation at Steps 201 to 209 shown in the flow chart of Fig. 2. More specifically, an initial value of a fill-in level $f_{mn}$ in the m row, the n column, a coupling strength $S_m(n)$ between a principal variable and an n-th variable of an m-th equation, and a coupling strength $E(m,n)$ between the m-th equation and an n-th equation are set (Step 501), a row number at which a factorized element value is to be actually calculated at the time of incomplete LU-factorization and a row number whose element is to be referred to at the time of incomplete LU-factorization are specified to check whether an element "$a_{ji}$" in the j row, the i column exists or not (Steps 502 to 506), and a column number at which a factorized element value is to be actually calculated at the time of incomplete LU-factorization is specified to check whether an element "$a_{ik}$" in the i row, the k column exists or not (Steps 507 to 509).

When the element "$a_{ik}$" exists at Step 509, the fill-in level calculation unit 106 sets a fill-in level $f_{jk}^{(new)}$ in the j row, the k column as shown in the following expressions (26) and (27) by using the fill-in level $f_{ik}$ in the i row, the k column, the coupling strength $S_i(k)$ of other k-th variable with an i-th principal variable constituting an i-th equation, the fill-in level $f_{ji}$ in the j row, the i column, the coupling strength $S_j(i)$ of other i-th variable with a j-th principal variable constituting a j-th equation, the coupling strength $E(i,j)$ between the i-th equation and the j-th equation (i.e. i row and j row) shown in Fig. 3 and the fill-in level $f_{jk}^{(old)}$ in the j row, the k column adopted before the processing (Step 510).

$$f_{jk}^{(eval)} = \left( \frac{f_{ik}}{S_i(k)} + \frac{f_{ji}}{S_j(i)} \right) \frac{1}{E(i,j)} \tag{26}$$

$$f_{jk}^{(new)} = \min[f_{jk}^{(eval)}, f_{jk}^{(old)}] \tag{27}$$

Operation from Step 511 on is the same as that from Step 211 on shown in the flow chart of Fig. 2. More specifically, the fill-in level $f_{jk}$ in the j row, the k column set at Step 510 is compared with a preset threshold value "C" to determine whether the fill-in level is to be adopted or discarded (Step 511) and when the fill-in level is to be adopted, a value of a fill-in element "$a_{jk}$" is calculated (Step 512) to check whether all the necessary determination for fill-in is completed or not (Steps 513 to 515) and finish the processing.

Since the present operation example obtains a new fill-in level by using a sum of existing fill-in levels generated before the processing as mentioned above, it is characterized in that a fill-in level changes more moderately than the operation example shown in Fig. 2. This brings the following advantages. That is, although even the present embodiment needs resetting of a fill-in level when a computer is short of a storage region, the resetting is easy because fill-in level change is moderate.

As described in the foregoing, since a fill-in generation position is determined taking a coupling strength between variables of an equation and a coupling strength between equations into consideration, the fill-in generation device and the method thereof of the present invention enable a smaller amount of fill-in generation to obtain results approximate to those obtained by complete LU-factorization than that required for a device and a method according to which a fill-in generation position is determined solely by information on nonzero element arrangement of a coefficient matrix. This makes possible reduction in a fill-in storage region of a computer.

In addition, since a fill-in generation position can be determined at the stage of symbolic LU-factorization, no change will be made in a fill-in generation position, which eliminates restructuring of a storage region on a computer. As a result, as compared with a conventional method of determining a generation position while calculating an element value every time when incomplete LU-factorization is numerically conducted, a calculation time can be further reduced to enable execution of incomplete LU-factorization at higher speed.

Moreover, since obtaining a new fill-in level by using a sum of existing fill-in levels generated before the processing will result in having a fill-in level calculation value moderately changing, necessary resetting of a fill-in level can be executed with ease.

## Claims

1.  A fill-in generation device for executing, in order to conduct matrix solver for solving multi-dimensional simultaneous linear equations by an iteration method subjected to preconditioning by incomplete LU-factorization in semiconductor device manufacturing process simulations, preconditioning by said incomplete LU-factorization to generate a fill-in, comprising:

    parameter setting means (101) for setting an initial fill-in level, a coupling strength $E(i,j)$ between an i-th equation and a j-th equation, a coupling strength $S_i(k)$ of other k-th variable with an i-th principal variable constituting the i-th equation and a coupling strength $S_j(i)$ of other i-th variable with a j-th principal variable constituting the j-th equation so as to reflect physical phenomena of equations to be solved,
    fill-in level calculation means (106) for calculating, at the time of symbolic incomplete LU-factorization conducted for determining a fill-in generation position before said incomplete LU-factorization is numerically conducted, a level of a fill-in whose generation is possible according to a calculation expression using a fill-in level $f_{ik}^{(old)}$ in the i row, the k column and a fill-in level $f_{ji}^{(old)}$ in the j row, the i column adopted before the processing
    a fill-in level check means (107) for, when the value of said fill-in level calculated by said fill-in level calculation means (106) is not more than a preset threshold value, adopting said fill-in as a fill-in and when the same is more than the threshold value, discarding said fill-in to control a fill-in generation position, and
    fill-in element calculation means (108) for calculating a value of an element newly generated at a fill-in generation position whose adoption is determined by said fill-in level check means (107).

2.  The fill-in generation device according to claim 1, wherein

    said fill-in level calculation means (106) calculates a level $f_{jk}^{(new)}$ of said fill-in whose generation is possible according to the following expressions:

    $$f_{jk}^{(eval)} = \left( \frac{f_{ik}}{S_i(k)} \cdot \frac{f_{ji}}{S_j(i)} \right) \frac{1}{E(i,j)}$$

    $$f_{jk}^{(new)} = min[f_{jk}^{(eval)}, f_{jk}^{(old)}]$$

3.  The fill-in generation device according to claim 1, wherein

    said fill-in level calculation means (106) calculates a level $f_{jk}^{(new)}$ of said fill-in whose generation is possible according to the following expressions:

$$f_{jk}^{(eval)} = \left( \frac{f_{ik}}{S_i(k)} + \frac{f_{ji}}{S_j(i)} \right) \frac{1}{E(i,j)}$$

$$f_{jk}^{(new)} = \min[f_{jk}^{(eval)}, f_{jk}^{(old)}]$$

4. A fill-in generation method for executing, in order to conduct matrix solver for solving multi-dimensional simultaneous linear equations by an iteration method subjected to preconditioning by incomplete LU-factorization in semiconductor device manufacturing process simulations, preconditioning by said incomplete LU-factorization to generate a fill-in, comprising the steps of:

setting an initial fill-in level, a coupling strength $E(i,j)$ between an i-th equation and a j-th equation, a coupling strength $S_i(k)$ of other k-th variable with on i-th principal variable constituting the i-th equation and a coupling strength $S_j(i)$ of other i-th variable with a j-th principal variable constituting the j-th equation so as to reflect physical phenomeena of equations to be solved
calculating, at the time of symbolic incomplete LU-factorization conducted for determining a fill-in generation position before said incomplete LU-factorization is numerically conducted, a level of a fill-in whose generation is possible according to a calculation expression using a fill-in level $f_{ik}^{(old)}$ in the i row, the k column and a fill-in level $f_{ji}^{(old)}$ in the j row, the i column adopted before the processing,
when the value of said fill-in level calculated at said fill-in level calculation step is not more than a preset threshold value, adopting said fill-in as a fill-in and when the same is more than the threshold value, discarding said fill-in to control a fill-in generation position, and
calculating a value of an element newly generated at a fill-in generation position whose adoption is determined by said fill-in level checking step.

5. The fill-in generation method according to claim 4, wherein

at said fill-in level calculation step, a level $f_{jk}^{(new)}$ of said fill-in whose generation is possible is calculated according to the following expressions:

$$f_{jk}^{(eval)} = \left( \frac{f_{ik}}{S_i(k)} \cdot \frac{f_{ji}}{S_j(i)} \right) \frac{1}{E(i,j)}$$

$$f_{jk}^{(new)} = \min[f_{jk}^{(eval)}, f_{jk}^{(old)}]$$

6. The fill-in generation method according to claim 4, wherein

at said fill-in level calculation step, a level $f_{jk}^{(new)}$ of said fill-in whose generation is possible is calculated according to the following expressions:

$$f_{jk}^{(eval)} = \left( \frac{f_{ik}}{S_i(k)} + \frac{f_{ji}}{S_j(i)} \right) \frac{1}{E(i,j)}$$

$$f_{jk}^{(new)} = \min[f_{jk}^{(eval)}, f_{jk}^{(old)}]$$

# FIG. 1

FILL-IN GENERATION DEVICE

PARAMETER SETTING UNIT ～101

INCOMPLETE LU-FACTORIZATION ROW NUMBER COUNTER CONTROL UNIT ～102

INCOMPLETE LU-FACTORIZATION ROW NUMBER CHECK UNIT 111

INCOMPLETE LU-FACTORIZATION TARGET ROW NUMBER COUNTER CONTROL UNIT ～103

INCOMPLETE LU-FACTORIZATION TARGET ROW NUMBER CHECK UNIT 110

MATRIX ELEMENT CHECK UNIT ～104

INCOMPLETE LU-FACTORIZATION COLUMN NUMBER COUNTER CONTROL UNIT ～105

INCOMPLETE LU-FACTORIZATION COLUMN NUMBER CHECK UNIT 109

FILL-IN LEVEL CALCULATION UNIT ～106

FILL-IN LEVEL CHECK UNIT ～107

FILL-IN ELEMENT CALCULATION UNIT ～108

120～ STORAGE MEDIUM

# FIG. 2

```
START
```

SET  f mn, Sm(n), E(m,n)  — 201

j = 0  — 202

j = j + 1  — 203

i = 0  — 204

i = i + 1  — 205

aji $\neq$ 0 ?  — 206
YES / NO

k = i  — 207

k = k + 1  — 208

aik $\neq$ 0 ?  — 209
YES / NO

$$f_{jk}^{(eval)} = (f_{ik}/Si(k)*f_{ji}/Sj(i))/E(i,j)$$

$$f_{jk}^{(new)} = min\,[\,f_{jk}^{(eval)}, f_{jk}^{(old)}\,]$$

— 210

fjk $\leqq$ C?  — 211
YES / NO

ajk = ajk - aji * aik  — 212

k = N ?  — 213
NO / YES

i = j - 1 ?  — 214
NO / YES

j = N ?  — 215
NO / YES

```
END
```

## FIG. 3

## FIG. 4

# FIG. 5

START

| SET f mn, Sm(n), E(m,n) | ~ 501 |

| j = 0 | ~ 502 |

| j = j + 1 | ~ 503 |

| i = 0 | ~ 504 |

| i = i + 1 | ~ 505 |

506 — $a_{ji} \neq 0$ ?  — NO

YES

| k = i | ~ 507 |

| k = k + 1 | ~ 508 |

509 — $a_{ik} \neq 0$ ? — NO

YES

$$f_{jk}^{(eval)} = (f_{ik}/Si(k) + f_{ji}/Sj(i))/E(i,j)$$

$$f_{jk}^{(new)} = \min [ f_{jk}^{(eval)}, f_{jk}^{(old)} ]$$

~ 510

511 — $f_{jk} \leqq C$? — NO

YES

| $a_{jk} = a_{jk} - a_{ji} * a_{ik}$ | ~ 512 |

NO — 513 — k = N ?

YES

NO — 514 — i = j - 1 ?

YES

NO — 515 — j = N ?

YES

END

# FIG. 6

i-TH ROW

j-TH ROW

i-TH
COLUMN

k-TH
COLUMN

j-TH
COLUMN

ajk = -aji * aik

# FIG. 7
## ( PRIOR ART )

```
                    ┌─────────┐
                    │  START  │
                    └─────────┘
                         │
   ┌──────────────────────────────────────────┐
   │  fmn = 0  for  amn ≠ 0                     │ ~ 701
   │  fmn = N  for  amn = 0                     │
   └──────────────────────────────────────────┘
                         │
   ┌──────────────────────────────────────────┐
   │                 j = 0                      │ ~ 702
   └──────────────────────────────────────────┘
                         │
   ┌──────────────────────────────────────────┐
   │               j = j + 1                    │ ~ 703
   └──────────────────────────────────────────┘
                         │
   ┌──────────────────────────────────────────┐
   │                 i = 0                      │ ~ 704
   └──────────────────────────────────────────┘
                         │
   ┌──────────────────────────────────────────┐
   │               i = i + 1                    │ ~ 705
   └──────────────────────────────────────────┘
                         │
              < aji ≠ 0 ? >                       ~ 706
              YES         NO
                         │
   ┌──────────────────────────────────────────┐
   │                 k = i                      │ ~ 707
   └──────────────────────────────────────────┘
                         │
   ┌──────────────────────────────────────────┐
   │               k = k + 1                    │ ~ 708
   └──────────────────────────────────────────┘
                         │
              < aik ≠ 0 ? >                       ~ 709
              YES         NO
```

$$f_{jk}^{(new)} = \min [\, f_{ji} + f_{jk} + 1,\ f_{jk}^{(old)}\,]$$  ~ 710

```
              < fjk ≤ C? >                        ~ 711
              YES         NO

   ┌──────────────────────────────────────────┐
   │           ajk = ajk - aji * aik            │ ~ 712
   └──────────────────────────────────────────┘

        NO    < k = N ? >                         ~ 713
              YES

        NO    < i = j - 1 ? >                     ~ 714
              YES

        NO    < j = N ? >                         ~ 715
              YES
                    ┌─────────┐
                    │   END   │
                    └─────────┘
```

# FIG. 8
## ( PRIOR ART )

```
                    START

            j = 0                    ~ 801

            j = j + 1                ~ 802

      a_j^(max) = max [ | a_ji | ]    ~ 803

            i = 0                    ~ 804

            i = i + 1                ~ 805

            aji ≠ 0 ?                ~ 806
        YES              NO

            k = i                    ~ 807

            k = k + 1                ~ 808

            aik ≠ 0 ?                ~ 809
        YES              NO

        ajk = aji * aik              ~ 810

        a_jk ≥ τ a_j^(max) ?          ~ 811
        YES              NO

     ajk = ajk - aji * aik           ~ 812

  NO        k = N ?                  ~ 813
            YES

  NO        i = j - 1 ?              ~ 814
            YES

  NO        j = N ?                  ~ 815
            YES

            END
```